# EUROPEAN PATENT SPECIFICATION

(11) **EP 3 396 394 B1**
(45) Date of publication and mention of the grant of the patent: **27.11.2019**
(21) Application number: 17168005.1
(22) Date of filing: 25.04.2017
(51) Int. Cl.: G01R 31/04

(54) **A MEMRISTOR BASED SYSTEM FOR DETECTING POOR-CONTACT OF SOCKETS**
AUF MEMRISTOR BASIERENDES SYSTEM ZUR ERKENNUNG VON MANGELHAFTEN BUCHSENKONTAKTEN
SYSTÈME DE DÉTECTION DE MAUVAIS CONTACT DE PRISES À BASE DE MEMRISTANCE

(43) Date of publication of application: 31.10.2018
(73) Proprietor: Vestel Elektronik Sanayi ve Ticaret A.S., 45030 Manisa (TR)
(72) Inventor: ÖZKÜÇÜK, Serhat, 45030 Manisa (TR)
(74) Representative: Ascherl, Andreas

(56) References cited:
- WO-A1-2015/038664
- DE-A1-102014 116 298
- US-A1- 2016 178 682

## Description

This invention refers to a memristor based system for detecting poor-contact of sockets according to claim 1.

### Background of the Invention

All electronic devices can establish an electrical contact with help of a socket. In the market, several socket types such as locked, unlocked, edge and so on are available. Connections inside these sockets can be done either by employees manually or by machines automatically. However, due to manufacturing defect connections may not be perfect for some sockets. That means that the socket may have contact but is not locked properly. In some cases the socket may have poor contact or non-contact. Mostly, these types of problems occur when the manufacturing is performed by machines. Usually, these connection problems cannot be detected on production line, since the sockets are tested using uninterrupted spikes/surge free electricity during production time.

Some poorly plugged socket cannot be detected until the socket is used by a customer. The non-contact socket raises problems in the customer home because of transportation, placement or work of product. Some poor contact socket causes electrical arc randomly and leads to causing fire, especially for edge sockets. Sometimes dangerous electrical arc or faults may damage the product that generally occurs on AC connectors. Therefore, a proper verification is required regarding safety of the customer as well as the electronic goods that are plugged in the socket. Thus, there is a need for a system to detect non-contact or poor contact of the sockets and to provide an alert to the customer accordingly.

The prior art CN104505669A discloses a trailer socket with open circuit warning function and a method thereof. The method for using the trailer socket and having a break alarm function applies specifically to increase break alarm function, to prevent disconnection due to lamp failure and due to security risks. The prior art having a break alarm function trailer socket and method of use. The system has a power input, alarm output terminal, chip resistors, detecting chip and lamp-pillars correspondence. The lamp pillar corresponds with each indicator to ensure that each lamp is equipped with a break alarm circuit to achieve break alarm function trailer socket, eliminate safety hazards. Accordingly, this prior art includes a circuit alarm function. However, the poor contact of the socket is not identified by the prior art CN104505669A.

Another prior art US6236171B1 discloses an image reading device including an image reading unit and a sheet feeding device attachable/detachable to/from the image reading unit, in which power is supplied from the image reading unit to the sheet feeding device only when the image reading unit and the sheet feeding device are securely engaged, whereby damage on an internal circuit of the sheet feeding device caused by an electric shock at the time of attachment/detachment is prevented. This prior art utilizes a microcontroller based detection system for detecting the non-contact of the socket with the AC supply line.

The subject-matter of CN104505669A and US6236171B1can detect only connect or non-contact sockets and not a poor contact of the sockets.

Further relevant documents are US 2016/178682 A1, WO 2015/038664 A1 and DE 10 2014 116298 A1.

### Object of the Invention

It is therefore the object of the present invention to provide an electronic device or system, in particular a memristor based system for detecting poor-contact of sockets that can detect the damages on the AC supply cable of a socket or wall socket in a better way compared to the known devices.

### Description of the Invention

The before mentioned object is solved by a memristor based system for detecting poor-contact of sockets according to claim 1. The memristor based system for detecting poor-contact of sockets according to the present invention preferably comprises of an AC socket connection, a side pad of AC line, a series resistor, a memristor and a microprocessor unit. The AC socket connection is provided for connecting line-neutral between a plug and the system. The side pad of AC line is provided for tracking changes in the AC line voltage or current. The series resistor is provided for limiting the current flow on the side pad of AC line.The memristor is provided for reading and recording all irregularity on the AC line voltage or current by means of memristance value.The microprocessor unit can be configured for providing alert on socket error. Further, the memristor can send the memristance value to the microprocessor unit. The microprocessor unit can be further configured for comparing said memristance value with a reference memristance value. Furthermore, the microprocessor unit can be configured to send alert on socket error to user when the microprocessor unit detects the change in memristance value with respect to the reference memristance value.

The memristor based detection system for non-contact or poor-contact of sockets according to the present invention can be applied for socket failure detection. Further, the Invention can be integrated with all electronics devices for detecting non-contact or poor contact of sockets. In addition to that the system can record data about the connection quality of AC lines.

Further preferred embodiments are subject-matter of dependent claims and/or of the following specification parts.

According to a preferred embodiment of the present invention a predetermined amount of energy from a main supply of the AC line is transferred through the side pad of AC line for checking contact status of the socket. The memristor can read the AC line continuously and can send the memristance data to the microprocessor unit for comparison. The memristance value can be changed according to the change in the current flow on to the memristor. The memristance value decreases when the current flow on memristor increases and vice versa. The socket is considered as good-contact socket for a regular AC line voltage, if there is no change in the memristance data.

According to a further preferred embodiment of the present invention, the reference memristance is obtained by the microprocessor unit when the socket can establish a perfect connection with the main supply. The reference memristance is determined for one cycle of the AC line voltage or current from the main supply. The system can start to perform comparison by itself with reference memristance, when the microprocessor unit determines the reference memristance.

Further benefits, goals and features of the present invention will be described by the following specification of the attached figures, in which components of the invention are exemplarily illustrated. Components of the devices and method according to the inventions, which match at least essentially with respect to their function can be marked with the same reference sign, wherein such components do not have to be marked or described in all figures.

The invention is just exemplarily described with respect to the attached figures in the following.

### Brief Description of the Drawings

- Fig. 1: illustrates the schematic diagram of a memristor based system for detecting poor-contact of sockets, according to an embodiment of the present invention; and
- Fig. 2: illustrates the graphical representation of voltage signal and memristance with respect to time, according to an embodiment of the present invention.

### Detailed Description of the Drawings

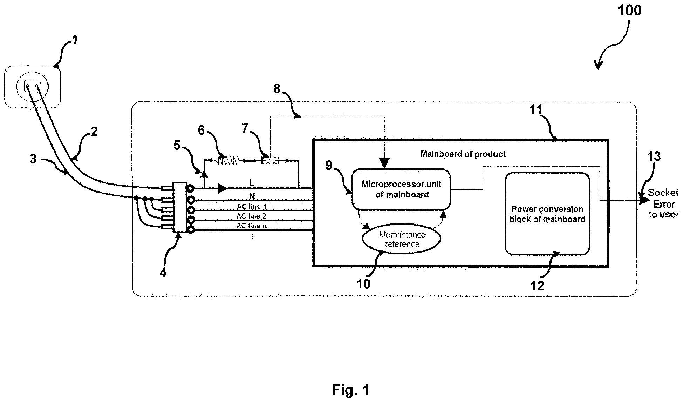

Fig. 1 illustrates the schematic diagram 100 of a memristor based system for detecting poor-contact of sockets, according to an embodiment of the present invention. The memristor based system for detecting poor-contact of sockets according to the present invention preferably comprises of an AC socket connection 4, a side pad of AC line 5, a series resistor 6, a memristor 7 and a microprocessor unit 9. The AC socket connection 4 is provided for connecting line 2-netural 3 between a plug 1 and the system. The line 2 from the plug 1 is connected to the line (L) of the AC socket provided in the electronic device. Further, the neutral 3 of the plug 1 or main supply 1 is connected to the neutral 3 of the AC socket. The side pad of AC line 5 is provided for tracking changes in the AC line voltage or current. The series resistor 6 is provided for limiting the current flow on the side pad of AC line 5. The memristor 7 is provided for reading and recording all irregularity on the AC line voltage or current by means of memristance value. The memristance value is transferred as a memristance data 8 to the microprocessor unit 9.

According to a preferred embodiment of the present invention, a mainboard 11 of an electronic device 8 for detecting poor-contact of sockets comprises of microprocessor unit 9, power conversion block 12 or power supply 12 for mainboard 11, and reference memristance 10 for comparison. The microprocessor unit 9 can be configured for providing alert on socket error 13. Further, the microprocessor unit 9 configured for accepting the memristance data 8 from the memristor 7. The microprocessor unit 9 can be further configured for comparing said memristance value with a reference memristance value 10. Furthermore, the microprocessor unit 9 can be configured to send alert on socket error 13 to user when the microprocessor unit 9 can detect the change in memristance value with respect to the reference memristance value 10.

According to a further embodiment of the present invention, a predetermined amount of energy from a main supply 1 of the AC line is transferred through the side pad of AC line 5 for checking contact status of the socket. That is a portion of current from the main supply 1 is transferred to the memristor 7 through the series resistor 6. The series resistor 6 is connected in series with the side pad of AC line 5 and before the memristor 7. The system can be designed for all kind of socket failure detection. Further, the system can be integrated and used in all electronics devices according to the requirement. The system can return data about connection quality of the AC lines.

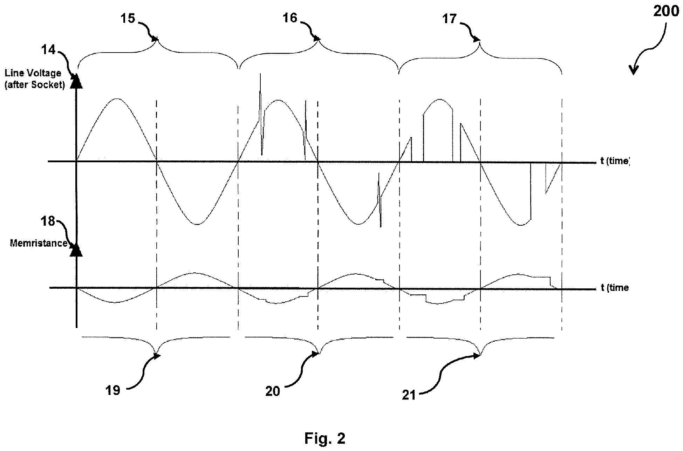

Fig. 2 illustrates the graphical representation 200 of voltage signal and memristance with respect to time, according to an embodiment of the present invention. The graphical representation of the voltage signal with respect to time period 14 depicts the voltage signal amplitude and time variation for a regular voltage or reference voltage 15, voltages with spikes 16, and voltages with interruption 17. Similarly, the graphical representation of the memristance with respect to time period 18 depicts the memristance amplitude and time variation for a reference memristance 19, change in memristance when voltage contains spikes 20, and change in memristance when voltage contains interruption 21.

According to a further preferred embodiment of the present invention, the reference memristance 10 is obtained by the microprocessor unit 9 when the socket can establish a perfect connection with the main supply 1. The reference memristance 10 is determined for one cycle of the AC line voltage or current from the main supply 1. The system can start to perform comparison by itself with reference memristance 10, when the microprocessor unit 9 determines the reference memristance 10. The memristor 7 can read the AC line continuously and can send the memristance data 8 to the microprocessor unit 9 for comparison. The memristance value can be changed according to the change in the current flow on to the memristor 7. The memristance value decreases when the current flow on memristor 7 increases and vice versa. The socket is considered as good-contact socket for a regular AC line voltage, if there is no change in the memristance data 8.

Thus, the present invention refers to a memristor 7 based system for detecting poor-contact of sockets according to the present invention preferably comprises of an AC socket connection 4, a side pad of AC line 5, a series resistor 6, a memristor 7 and a microprocessor unit 9. The AC socket connection 4 is provided for connecting line 2 - neutral 3 between a plug 1 and the system. From the AC socket connection 4 a portion of current is bypassed to the series resistor 6 using the side pad of AC line 5 for tracking changes in the AC line voltage or current. The series resistor 6 is connected in series with the memristor 7 and the memristor 7 can read and record all irregularity on the AC line voltage or current by means of memristance value. The microprocessor unit 9 can be configured for comparing said memristance value with a reference memristance value 10 and for providing alert to a user on socket error 13.

### List of reference numbers

- 1: plug or main supply 1
- 2: line
- 3: neutral
- 4: AC socket connection
- 5: side pad of AC line
- 6: series resistance or current limiting resistor
- 7: memristor
- 8: memristance data
- 9: microprocessor unit
- 10: reference memristance
- 11: mainboard of the electronic device
- 12: power conversion block of mainboard
- 13: socket error alert to user
- 14: line voltage
- 15: reference voltage
- 16: voltage spikes
- 17: voltage interruption
- 18: memristance
- 19: reference memristance
- 20: change in memristance for voltage spikes
- 21: change in memristance for voltage interruption
- 100: schematic diagram 100 of a memristor based system for detecting poor-contact of sockets
- 200: Graphical representation of the voltage signal and memristance with respect to time

## Claims

1. A memristor (7) based system for detecting poor-contact of sockets comprising an AC socket connection (4) for connecting line (2) - neutral (3) between a plug (1) and the system;
**characterized in that** the system further comprises a side pad of an AC line (5) for tracking changes in the AC line voltage or current; a series resistor (6) for limiting the current flow on the side pad of the AC line (5); a memristor (7) for reading and recording all irregularities on the AC line voltage or current by means of a memristance value; a microprocessor unit (9) for providing an alert on socket error (13); wherein the memristor (7) is configured to send the memristance value to the microprocessor unit (9); wherein the microprocessor unit (9) is configured for comparing said memristance value with a reference memristance value (10); and
wherein the microprocessor unit (9) is configured to send an alert on socket error (13) to a user when the microprocessor unit (9) detects a change in the memristance value with respect to the reference memristance value (10).

2. The system of claim 1, wherein a predetermined amount of energy from a main supply (1) of the AC line is transferred through the side pad of AC line (5) for checking contact status of the socket.

3. The system of claim 1, wherein the memristor (7) reads the AC line continuously and sends the memristance data 8 to the microprocessor unit (9) for comparison.

4. The system of claim 1, wherein the memristance value changes according to the change in current flow on to the memristor (7).

5. The system of claim 1, wherein the memristance value decreases when the current flow on memristor (7) increases and vice versa.

6. The system of claim 1, wherein the socket is considered as good-contact socket for a regular AC line voltage, if there is no change in the memristance data (8).

7. The system of claim 1, wherein the reference memristance (10) is obtained by the microprocessor unit (9) when the socket establishes a perfect connection with the main supply (1).

8. The system of claim 7, wherein the reference memristance (10) is determined for one cycle of the AC line voltage or current from the main supply (1).

9. The system of claim (8), wherein the system starts to perform comparison by itself with reference memristance (10), when the microprocessor unit (9) determines the reference memristance (10).

## Patentansprüche

1. Ein auf einem Memristor (7) basierendes System zum Erfassen eines schlechten Kontakts von Steckdosen, umfassend,
eine AC-Steckdosenverbindung (4) zum Verbinden der Leitung (2) - neutral (3) zwischen einem Stecker (1) und dem System;
**dadurch gekennzeichnet, dass** das System ferner umfasst
ein Seitenpolster einer Wechselstromleitung (5) zum Verfolgen von Änderungen der Wechselstromspannung oder -strom;
einen Vorwiderstand (6) zum Begrenzen des Stromflusses auf dem Seitenpolster der Wechselstromleitung (5);
einen Memristor (7) zum Lesen und Aufzeichnen aller Unregelmäßigkeiten auf der Wechselstrom-Netzspannung oder dem Wechselstrom mittels eines Memristance-Wertes;
eine Mikroprozessoreinheit (9) zum Bereitstellen einer Warnung bei einem Sockelfehler (13);
wobei der Memristor (7) konfiguriert ist, um den Memristance-Wert an die Mikroprozessoreinheit (9) zu senden;
wobei die Mikroprozessoreinheit (9) konfiguriert ist, um den Memristance-Wert mit einem Referenz-Memristance-Wert (10) zu vergleichen; und
wobei die Mikroprozessoreinheit (9) konfiguriert ist, um einen Alarm bei einem Sockelfehler (13) an einen Benutzer zu senden, wenn die Mikroprozessoreinheit (9) eine Änderung des Speicherwertes in Bezug auf den Referenzspeicherwert (10) erfasst.

2. System nach Anspruch 1, wobei eine vorbestimmte Energiemenge von einer Hauptversorgung (1) der Wechselstromleitung durch das Seitenpolster der Wechselstromleitung (5) übertragen wird, um den Kontaktzustand der Steckdose zu überprüfen.

3. System nach Anspruch 1, wobei der Memristor (7) die Wechselstromleitung kontinuierlich liest und die Memristanzwerte (8) zum Vergleich an die Mikroprozessoreinheit (9) sendet.

4. System nach Anspruch 1, wobei sich der Memristance-Wert entsprechend der Änderung des Stromflusses zum Memristor (7) ändert.

5. System nach Anspruch 1, wobei der Memristance-Wert abnimmt, wenn der Stromfluss auf dem Memristor (7) steigt und umgekehrt.

6. System nach Anspruch 1, wobei die Steckdose als Gutkontakt-Steckdose für eine regelmäßige Wechselstrom-Netzspannung betrachtet wird, wenn sich die Speicherdaten (8) nicht ändern.

7. System nach Anspruch 1, worin der Referenz-Memristance-Wert (10) durch die Mikroprozessoreinheit (9) erhalten wird, wenn die Steckdose eine perfekte Verbindung mit der Hauptversorgung (1) herstellt.

8. System nach Anspruch 7, wobei der Referenz-Memristance-Wert (10) für einen Zyklus der Wechselstrom-Netzspannung oder -Strom aus der Hauptstromversorgung (1) bestimmt wird.

9. Anspruchssystem (8), wobei das System beginnt, selbstständig einen Vergleich mit dem Referenz-Memristance-Wert (10) durchzuführen, wenn die Mikroprozessoreinheit (9) den Referenz-Memristance-Wert (10) bestimmt.

## Revendications

1. Système basé sur un memristor (7) pour détecter un mauvais contact des prises femelles, comprenant :
une prise de courant alternatif (4) pour la ligne de raccordement (2) - neutre (3) entre une fiche (1) et l'installation ;
**caractérisé en ce que** le système comprend en outre
une plaquette latérale d'une ligne AC (5) pour suivre les variations de la tension ou du courant de la ligne AC ;
une résistance en série (6) pour limiter le flux de courant sur le plot latéral de la ligne AC (5) ;
un memristor (7) pour lire et enregistrer toutes les irrégularités sur la tension ou le courant alternatif au moyen d'une valeur de memristance ;
une unité à microprocesseur (9) pour fournir une alerte sur une erreur de socket (13) ;
dans laquelle le memristor (7) est configuré pour envoyer la valeur de la résistance de mémoire à l'unité à microprocesseur (9) ;
dans laquelle l'unité à microprocesseur (9) est configurée pour comparer ladite valeur de résistance de mémoire avec une valeur de résistance de mémoire de référence (10) ; et
dans laquelle l'unité à microprocesseur (9) est configurée pour envoyer une alerte sur une erreur de socket (13) à un utilisateur lorsque l'unité à microprocesseur (9) détecte un changement dans la valeur de mémorisation par rapport à la valeur de memristance de référence (10).

2. Système selon la revendication 1, dans lequel une quantité prédéterminée d'énergie provenant d'une alimentation principale (1) de la ligne c.a. est transférée à travers le panneau latéral de la ligne c.a. (5) pour vérifier l'état des contacts de la prise.

3. Système selon la revendication 1, dans lequel le memristor (7) lit la ligne CA en continu et envoie les valeurs de résistance de mémoire (8) à l'unité à microprocesseur (9) pour comparaison.

4. Système selon la revendication 1, dans lequel la valeur de la résistance de mémorisation varie en fonction de la variation du flux de courant sur le memristor (7).

5. Système selon la revendication 1, dans lequel la valeur de la résistance de mémoire diminue lorsque le flux de courant sur la résistance de mémoire (7) augmente et vice versa.

6. Système selon la revendication 1, dans lequel la prise est considérée comme une prise à bon contact pour une tension de ligne alternative régulière, s'il n'y a pas de changement dans les données de distance mémoire (8).

7. Système selon la revendication 1, dans lequel la mémoire de référence (10) est obtenue par l'unité à microprocesseur (9) lorsque la douille établit une connexion parfaite avec l'alimentation principale (1).

8. Système selon la revendication 7, dans lequel la résistance de référence (10) est déterminée pour un cycle de la tension ou du courant alternatif de la ligne d'alimentation principale (1).

9. Système de revendication (8), dans lequel le système commence à effectuer une comparaison par lui-même avec la memristance de référence (10), lorsque l'unité microprocesseur (9) détermine la memristance de référence (10).
